# EUROPÄISCHE PATENTSCHRIFT

(11) **EP 1 614 725 B1**
(45) Veröffentlichungstag und Bekanntmachung des Hinweises auf die Patenterteilung: **03.10.2007**
(21) Anmeldenummer: 04016254.7
(22) Anmeldetag: 09.07.2004
(51) Int. Cl.: C09D 11/00, H05K 1/09

(54) **Elektrisch leitfähige Ink-Jet Tinte**
Electrically conductive ink jet ink
Encre à jet d'encre électriquement conductrice

(43) Veröffentlichungstag der Anmeldung: 11.01.2006
(73) Patentinhaber: TETENAL AG & Co. KG., 22844 Norderstedt (DE)
(72) Erfinder: De Rossi, Umberto, Dr., 22844 Norderstedt (DE)
(74) Vertreter: Glawe, Delfs, Moll

(56) Entgegenhaltungen:
- EP-A- 1 229 088
- US-A- 5 494 609
- US-A- 5 626 948
- US-A1- 2002 016 440
- US-A1- 2002 136 988

## Beschreibung

Die Erfindung betrifft eine Ink-Jet Tinte, die ein elektrisch leitfähiges Polymer aufweist. Tinten zum Drucken sind aus den Stand der Technik, beispielsweise US-A-2002/0016440, US-A-5,494,609, EP-A-1 229 088 und US-A-5,626, 948 bekannt.

Elektrisch leitende organische Polymere sind von zunehmender Bedeutung für verschiedene technologische Bereiche, z. B. spielen sie in der Herstellung von OLEDs, PLEDs und elektrolumineszierende Materialien eine Rolle, können als Antistatik-Schicht dienen und werden auf ihre Tauglichkeit als Leiterbahnen untersucht.

Momentan werden die organischen Polymere meist über Spin-Coating aufgetragen, eine Technik, bei der keine Möglichkeit zur Herstellung gezielter Muster besteht. Für die Herstellung von Pattern z. B. bei LEDs sowie bei der Erzeugung von dünnen homogenen Schichten wird momentan entweder der Siebdruck oder neuerdings auch das Ink-Jet genutzt. Durch das Ink-Jet Verfahren als non-impact-Verfahren können sehr kleine Flüssigkeitsmengen auf beliebige Materialien gesprüht werden.

Ink-Jet-Druckverfahren werden momentan für Polymer-Lösungen bei der Herstellung von OLEDs oder PLEDs verwendet. Unter anderem kommen z. B. PSS (Polystyrolsufonsäure) oder PEDOT (Poly(3,4-ethylendioxythiophene)) zum Einsatz, die in einem geeigneten Lösungsmittel gelöst werden.

Der Erfindung liegt die Aufgabe zugrunde, eine vielseitig verwendbare Tinte für Ink-Jet zu schaffen, die ein elektrisch leitfähiges Polymer enthält. Die Tinte soll im Ink-Jet-Druck gut verarbeitbar sein und die Herstellung einer elektrisch leitfähigen Beschichtung auf einem Substrat effizient und kostengünstig ermöglichen.

Erfindungsgemäß ist vorgesehen, dass das elektrisch leitfähige Polymer Polyanilin ist und in der Tinte als Feststoff dispergiert ist.

Die Erfindung hat erkannt, dass die im Stand der Technik übliche Verwendung von in der Tinte löslichen elektrisch leitfähigen Polymeren verschiedene Nachteile mit sich bringt. So wird bei höheren Konzentrationen eines löslichen Polymers die Viskosität der Tinte erhöht, dies wiederum schränkt die Verwendbarkeit im Ink-Jet-Druck ein. Soll eine Verarbeitung der Tinten bei Raumtemperatur erfolgen, können nur sehr geringe Polymerkonzentrationen eingesetzt werden. Verarbeitet man die Tinte mit dem darin gelösten Polymer bei höherer Temperatur, kann die Polymerkonzentration zwar erhöht werden, doch führt die Temperaturerhöhung zu Problemen im Druckerbetrieb, insbesondere einer Minderung der sogenannten Decap-Time des Druckkopfes sowie Wartungsproblemen. Gelöste höher molekulare Polymere können zudem die Tropfenform der Ink-Jet Tinte beeinflussen und damit das Druckbild verändern (Dergans et al., Adv. Mater. 2004, 16, Nr. 3, 203 bis 213).

Erfindungsgemäß ist dem gegenüber vorgesehen, dass die Ink-Jet Tinte das elektrisch leitfähige Polymer Polyanilin als in der Tinte dispergierten Feststoff enthält. Die erlaubt die Verwendung hoher Konzentrationen an leitfähigem Polymer ohne Erhöhung der Viskosität der Flüssigbestandteile der Tinte.

Als in der Tinte dispergierte Polymere können des weiteren beispielsweise Polyacethylene, Polypyrrole, Polythiophene, Polyphenylene, Poly(phenylensufide), Poly(Phenylenvinylene), Polyazulene, Polycarbazole, Polyindole, Polypyrene, Polyazepine, Polyfulvene, Polyindophenine verwendet werden. Nähere Offenbarung zu elektrisch leitfähigen Polymeren findet sich in Ullmann's Enzyclopedia of Industrial Chemistry, 6. Auflage, Band 28, Seite 329 ff.

Der Feststoffgehalt der Tinte kann zwischen vorzugsweise zwischen 0,1 und 50 Gew.-%, weiter vorzugsweise 0,2 und 20 Gew.-%, weiter vorzugsweise 0,5 bis 10 Gew.-%, besonders bevorzugt zwischen 1 und 4 Gew.-% betragen. Die mittlere Teilchengröße der eingesetzten elektrisch leitfähigen Polymere liegt bevorzugt unter 2 µm, besonders bevorzugt unter 1 µm. Dies stellt eine problemlose Verdruckbarkeit im Ink-Jet Verfahren sicher. Wenn in dieser Beschreibung und den Ansprüchen In-Jet-Tinten oder Ink-Jet-Verfahren erwähnt werden, so ist darunter allgemein einegefärbte oder ungefärbte Flüssigkeit, die zum Drucken durch Aufspritzen von Tröpfchen auf das zu bedruckende Substrat verwendet wird, bzw. das entsprechende Verfahren zu verstehen. Auch das sogenannte Piezo-Verfahren fällt darunter.

Die übrigen Bestandteile einer erfindungsgemäßen Tinte für Ink-Jet entsprechen dem Stand der Technik und sind dem Fachmann geläufig. Als Lösungsmittel (bevorzugter Anteil an der Tinte 10 bis 90 Gew.-%) können Wasser oder organische Lösungsmittel wie beispielsweise Alkohole, aromatische Kohlenwasserstoffe (Xylol, Toluol oder dergleichen) oder Ketone (beispielsweise MEK, NMP oder dergleichen) verwendet werden. Ebenfalls verwendbar sind Glykolether.

Ein weiterer Bestandteil der Tinte ist das erfindungsgemäße in Dispersion vorliegende elektrisch leitfähige Polymer. Es kann als bereits in einem Lösungsmittel vordispergiertes Konzentrat kommerziell erworben werden, beispielsweise von der Firma ORMECON unter den Handelsnamen D1005W und D1010.

In der erfindungsgemäßen Tinte können als Cosolventien bezeichnete Löse- oder Feuchthaltemittel in einem Gewichtsanteil von 0 bis 30 Gew.-% enthalten sein. Geeignete Feuchthaltemittel sind beispielsweise Glykole, Diole, Glykolether, Glykolester oder dergleichen. Wie die Bezeichnung Cosolventien bereits ausdrückt dienen solche Feuchthaltemittel in der Regel auch gleichzeitig als Trägerlösungsmittel.

Sofern die erfindungsgemäße Tinte wasserbasiert ist, können Puffer wie beispielsweise Triethanolamin verwendet werden. Biozide können in diesem Fall ebenfalls (bevorzugt in einer Menge von etwa 0,1 bis 3 Gew.-%) zugesetzt werden. Ein geeignetes Biozid ist beispielsweise Protectol^{®} HT (1,3,5-Tris-(2-Hydroxyethyl)Hexahydrotriazin, erhältlich von BASF).

Bei wässrigen Tinten können oberflächenaktive Stoffe bevorzugt in einer Menge von 0,1 bis 10 Gew.-% zugesetzt werden, bevorzugt handelt es sich um Tenside. Es könnten anionische, kationische, nicht ionische oder amphotere Tenside Verwendung finden. Geeignet sind beispielsweise Alkoholethoxylate, beispielhaft genannt sei Tergitol^{®} 15-S-7, erhältlich von Dow Chemical.

Gegenstand der Erfindung ist ferner ein Verfahren zum Herstellen einer elektrisch leitfähigen Beschichtung, mit den Schritten:
a) zur Verfügung stellen einer erfindungsgemäßen Ink-Jet Tinte gemäß den Ansprüchen 1 bis 7,
b) Bedrucken eines Substrats mit der Ink-Jet Tinte im Ink-Jet-Verfahren.

Als Substrate können insbesondere elektronische Bauelemente aller Art (Halbleiter aller Art, insbesondere LEDs wie OLEDs oder PLEDs) Verwendung finden. Das Verfahren ist auch für die Herstellung von Leiterbahnen auf Platinen anwendbar. Bevorzugte Leitfähigkeiten der bedruckten Bereiche der Substrate sind 0,2 bis 20 S/cm, bevorzugt 2 bis 20 S/cm, besonders bevorzugt 5 bis 15 S/cm. Das Substratmaterial kann beispielsweise ein Polymermaterial (Kunstharz oder dergleichen) sein. Es kann sich ebenfalls um ein metallisches Substrat handeln.

Gegenstand der Erfindung ist ferner ein bedrucktes Substrat, das durch das erfindungsgemäße Verfahren erhältlich ist.

Die Erfindung wird nachfolgend anhand von Ausführungsbeispielen erläutert.

### Beispiel 1

Eine wässrige Polyanilin-Dispersion von ORMECON (1005W) wird vordispergiert und in folgende Formulierung eingearbeitet:

| | |
|---|---|
| 4%ige Polyanilin-Dispersion | 65 % |
| Ethylenglycol | 23 % |
| 1,2 - Hexandiol | 8 % |
| Triethanolamin | 1 % |
| Protectol HT | 1% |
| Surfactant 15 S 7 (1:100) | 0,5 % |

Die Oberflächenspannung betrug 32 mN/m, die Viskosität 4,2 mPas. Über einen handelsüblichen Ink-jet Drucker Epson 1290 wird die Tinte auf PE-Folie gedruckt. Nach der Trocknung erhält man einen homogenen transparenten etwas grünlichen Film. Die Leitfähigkeit des getrockneten Films betrug 5 S/cm. Es gab keine Druckprobleme. Die Tinte zeigt über 3 Monate keine Agglomerationen oder Sedimentation.

### Beispiel 2

Eine Polyanilin-Dispersion (4%) auf Xylol-Basis von ORMECON D1010wird vordispergiert und in folgende Formulierung eingearbeitet:

| | |
|---|---|
| 4%ige PANI-Dispersion | 69 % |
| Vilit MC31 (Hüls) Vinylchlorid-Copolymer | 0,2 % |
| Isopar L | 8 % |
| Exxol D140 | 20 % |

Isopar L und Exxol D140 sind von der Firma Exxon Mobil erhältliche Kohlenwasserstoffgemische.

Die Formulierung wird durch einen NOVA JA-256/80 Spectra Kopf auf einen PE-Träger verdruckt. Die Dispersion war > 3 Monate stabil. Nach Trocknung erhält man einen homogenen transparenten grünlichen Film mit einer Leitfähigkeit von 8 S/cm.

## Patentansprüche

1. Verwendung von Tinte, die ein elektrisch leitfähiges Polymer enthält, **dadurch gekennzeichnet, dass** das elektrisch leitfähige Polymer Polyanilin ist und in der Tinte als Feststoff dispergiert ist für Ink-Jet.

2. Verwendung nach Anspruch 1, **dadurch gekennzeichnet, dass** der Feststoffgehalt 0,1 - 50 Gew.-%, vorzugsweise 0,2 - 20 Gew.-%, weiter vorzugsweise 0,5 - 10 Gew.-%, weiter vorzugsweise 1 - 4 Gew.-% beträgt.

3. Verwendung nach einem der Ansprüche 1 oder 2, **dadurch gekennzeichnet, dass** die mittlere Teilchengröße des elektrisch leitfähigen Polymers unter 2 µm, vorzugsweise unter 1 µm liegt.

4. Verwendung nach einem der Ansprüche 1 bis 3, **dadurch gekennzeichnet, dass** die Tinte als Trägerlösungsmittel Wasser oder ein organisches Lösungsmittel enthält.

5. Verwendung nach Anspruch 4, **dadurch gekennzeichnet, dass** das organische Lösungsmittel ausgewählt ist aus der Gruppe bestehend aus Alkoholen, aromatischen Kohlenwasserstoffen und Ketonen.

6. Verwendung nach einem der Ansprüche 1 bis 5, **dadurch gekennzeichnet, dass** die Tinte Cosolventien enthält.

7. Verwendung nach Anspruch 6, **dadurch gekennzeichnet, dass** die Cosolventien ausgewählt sind aus der Gruppe bestehend aus Glykolen, Diolen, Glykolethern und Glykolestern.

8. Verfahren zum Herstellen einer elektrisch leitfähigen Beschichtung, mit den Schritten:
a) zur Verfügung stellen einer Ink-Jet Tinte nach einem der Ansprüche 1 bis 7,
b) Bedrucken eines Substrats mit der Ink-Jet Tinte im Ink-Jet-Verfahren.

9. Bedrucktes Substrat, erhältlich durch ein Verfahren nach Anspruch 8, **dadurch gekennzeichnet, dass** die bedruckten Bereiche eine elektrische Leitfähigkeit von 0,2 -20 S/cm bevorzugt 2 - 20 S/cm, vorzugsweise 5 - 15 S/cm aufweist.

10. Bedrucktes Substrat nach Anspruch 9, **dadurch gekennzeichnet, dass** das Substratmaterial ein Polymermaterial ist.

## Claims

1. Use of ink comprising an electrically conductive polymer, **characterized in that** the electrically conductive polymer is polyaniline and is dispersed in the ink as a solid for ink jet.

2. Use according to Claim 1, **characterized in that** the solids content is 0.1-50% by weight, preferably 0.2-20% by weight, more preferably 0.5-10% by weight, more preferably 1-4% by weight.

3. Use according to either of Claims 1 and 2, **characterized in that** the average particle size of the electrically conductive polymer is below 2 µm, preferably below 1 µm.

4. Use according to any one of Claims 1 to 3, **characterized in that** the ink includes water or an organic solvent as carrier solvent.

5. Use according to Claim 4, **characterized in that** the organic solvent is selected from the group consisting of alcohols, aromatic hydrocarbons and ketones.

6. Use according to any one of Claims 1 to 5, **characterized in that** the ink includes cosolvents.

7. Use according to Claim 6, **characterized in that** the cosolvents are selected from the group consisting of glycols, diols, glycol ethers and glycol esters.

8. Process for producing an electrically conductive coating, comprising the steps of:
a) providing an ink jet ink according to any one of Claims 1 to 7,
b) printing a substrate with the ink jet ink in the ink jet process.

9. Printed substrate obtainable by a process according to Claim 8, **characterized in that** the printed regions have an electrical conductivity of 0.2-20 S/cm preferably 2-20 S/cm and more preferably 5-15 S/cm.

10. Printed substrate according to Claim 9, **characterized in that** the substrate material is a polymer material.

## Revendications

1. Utilisation d'une encre qui contient un polymère électriquement conducteur, **caractérisé en ce que** le polymère électriquement conducteur est la polyaniline et est dispersé dans l'encre sous forme solide pour jet d'encre.

2. Utilisation selon la revendication 1, **caractérisée en ce que** la teneur en solides atteint 0,1 à 50 % en poids, de préférence 0,2 à 20 % en poids, plus préférentiellement 0,5 à 10 % en poids, encore plus préférentiellement 1 à 4 % en poids.

3. Utilisation selon l'une des revendications 1 ou 2, **caractérisée en ce que** la granulométrie moyenne du polymère électriquement conducteur se situe en dessous de 2 µm, de préférence en dessous de 1 µm.

4. Utilisation selon l'une des revendications 1 à 3, **caractérisée en ce que** l'encre contient, comme solvant support, de l'eau ou un solvant organique.

5. Utilisation selon la revendication 4, **caractérisée en ce que** le solvant organique est choisi dans le groupe constitué par les alcools, les hydrocarbures aromatiques et les cétones.

6. Utilisation selon l'une des revendications 1 à 5, **caractérisée en ce que** l'encre contient des co-solvants.

7. Utilisation selon la revendication 6, **caractérisée en ce que** les co-solvants sont choisis dans le groupe constitué par les glycols, les diols, les éthers de glycol et les esters de glycol.

8. Procédé de fabrication d'un revêtement électriquement conducteur, comprenant les étapes consistant à :
a) mettre à disposition une encre pour jet d'encre d'après l'une des revendications 1 à 7,
b) imprimer un substrat avec l'encre pour jet d'encre dans le procédé jet d'encre.

9. Substrat imprimé, pouvant être obtenu par un procédé selon la revendication 8, **caractérisé en ce que** les zones imprimées présentent une conductivité électrique de 0,2 à 20 S/cm, de préférence de 2 à 20 S/cm, de préférence de 5 à 15 S/cm.

10. Substrat imprimé selon la revendication 9, **caractérisé en ce que** le matériau du substrat est un matériau polymère.
